# EUROPEAN PATENT SPECIFICATION

(11) **EP 0 376 160 B1**
(45) Date of publication and mention of the grant of the patent: **02.03.1994**
(21) Application number: 89123662.2
(22) Date of filing: 21.12.1989
(51) Int. Cl.: H01L 21/00

(54) **Wafer positioning mechanisms for notched wafers**
Wafer-Positionierungsmechanismus für gekerbte Wafer
Mécanisme de positionnement de plaquettes semi-conductrices pour plaquettes entaillées

(30) Priority: 29.12.1988 JP 331141/88
(43) Date of publication of application: 04.07.1990
(73) Proprietor: FUJITSU LIMITED, Kawasaki-shi, Kanagawa 211 (JP)
(72) Inventor: Shimane, Kazuo c/o Fujitsu Limited, Nakahara-ku Kawasaki-shi Kanagawa 211 (JP)
(74) Representative: Sunderland, James Harry

(56) References cited:
- JP-A-62 219 535
- IBM TECHNICAL DISCLOSURE BULLETIN. vol. 14, no. 8, January 1972, NEW YORK US page 2448 A.R. JUKICH ET AL.: "Wafer notch orienter"

## Description

This invention relates to wafer positioning mechanisms, for positioning semiconductor wafers in wafer processing. More particularly, this invention relates to positioning mechanisms for semiconductor wafers having notches on the peripheries thereof, for setting notch positions to selected radial directions.

In the manufacture of semiconductor integrated circuits, especially in wafer processes, semiconductor wafers having a plurality of integrated circuit patterns formed thereon and being processed in order, are required to be positioned in fixed directions or orientations.

Generally, in the prior art, a generally circular semiconductor wafer is provided with a cut off portion which exhibits a segmental shape, formed by an arc and a chord. The resulting flat side surface of the wafer, formed by the cut off, is usually called an orientation flat and is formed in a specific direction with regard to orientation of the semiconductor crystal of the wafer. The orientation flat can be conveniently used for the purpose of wafer positioning. The orientation flat is formed at an early stage of a wafer manufacture process, by removing a side portion of a cylindrical ingot of semiconductor, parallel to the axis thereof, after the cylindrical ingot is grown. Semiconductor wafers, each with an orientation flat, are obtained by cutting the ingot into slices.

Wafers are usually carried or handled in a container, in other words, a semiconductor wafer carrier, during wafer processes, or before and after specific wafer processes in which wafers are processed one by one. Therefore, it is an important matter to position or to prealign a plurality of wafers in the carrier in a fixed direction or with a fixed alignment, in order to make wafer processes progress efficiently.

In lithography or test processes, in which each semiconductor wafer is processed individually, the orientation flat is generally utilised as a reference plane in positioning the wafer precisely at a predetermined position by moving a stage of the apparatus used for the process involved. To improve working efficiency for these processes, a procedure for prealignment of wafers in the carrier is a necessary step.

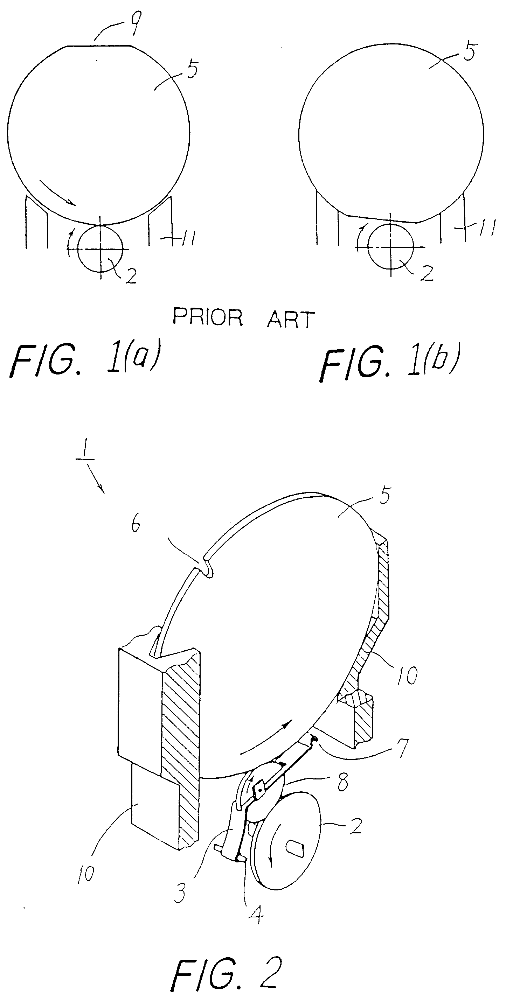

In the prior art, wafer positioning in the carrier has been performed mechanically using the orientation flat. A simple positioning procedure is explained with reference to Figs. 1(a) and 1(b). A semiconductor wafer 5 has an orientation flat 9, a straight flat portion thereof having a length ranging between about 30 mm and 50 mm, its dimensions being standardised depending on wafer size. The wafer is contained in the carrier and supported vertically and rotatably. For positioning the wafer 5, it is mounted on a drive roller 2 and the roller is rotated by a drive mechanism (not shown). When the circular periphery of the wafer is mounted on the roller 2, a small gap is formed between a wafer guide 11 and the wafer periphery, and the wafer 5 easily rotates as illustrated by arrows. When the orientation flat 9 rotates to a bottom position, confronting the roller 2, the wafer seats on the wafer guide 11 and ceases to rotate. When a carrier containing a plurality of wafers is positioned on a drive roller 2 of sufficient length and the drive roller 2 is rotated, all wafers are positioned at the same time by the single drive mechanism.

The above method has a disadvantage in that the accuracy of alignment is not so good. An improvement was proposed and disclosed in Japanese Unexamined Patent Publication "SHO-62-219535" laid-open on 26th September 1987, by T. Ohno.

In recent years, there is a trend towards the use of a wafer configuration having a notch, without an orientation flat. This is because a notched wafer is more economical, in that a larger area is available for forming integrated circuit chips than is the case for a wafer with an orientation flat. Further, the existence of the orientation flat has an adverse influence on uniformity in wafer processing. However, for a notched wafer, the notched area is so small compared with the cut off portion of an orientation flat that the simple positioning mechanism such as shown in Figs. 1(a) and 1(b) cannot be used for notched wafers.

According to the present invention there is provided a wafer positioning mechanism, for positioning a wafer with a notch in the periphery thereof, the positioning mechanism comprising:-
a drive roller, the centre axis thereof being substantially perpendicular to the main wafer surfaces, when the wafer is mounted for positioning by the mechanism, and being coupled to a drive source;
an arm member, a first end thereof being fixed and a second end having a protrusion and being elastically displaceable towards and away from the periphery of the wafer when the wafer is mounted for positioning by the mechanism, and the protrusion having a shape for fitting the notch in the periphery of the wafer;
a transmission roller, which is, with its periphery, in contact with the periphery of the wafer when the wafer is mounted for positioning by the mechanism, and which is supported by the arm member between the first and second ends thereof, the centre axis of the transmission roller being substantially parallel to the centre axis of the drive roller; and
holding means, for holding the arm member and drive roller in the vicinity of said wafer, so that said transmission roller is driven by said drive roller, whereby the wafer is rotated, when said protrusion is in contact with the wafer periphery outside the region where the notch is formed and so that the transmission roller loses contact with the drive roller when said protrusion is engaged with the notch.

An embodiment of the present invention can provide a wafer positioning mechanism for a notched wafer, for setting a wafer notch at a predetermined position.

An embodiment of the present invention can provide a wafer positioning mechanism for notched wafers, which has a simple mechanical structure.

An embodiment of the present invention can provide a wafer positioning mechanism for notched wafers, which accomplishes wafer positioning within a short time, over a single wafer rotation.

An embodiment of the present invention can provide a wafer positioning mechanism for positioning notched wafers placed in a wafer carrier.

A positioning mechanism in accordance with an embodiment of the present invention can be used for positioning an arbitrary selected number of wafers all at one time. Each wafer is positioned individually by a separate arm member having a transmission roller, and thus a plurality of wafers can be positioned by providing a combined structure with a plurality of individual arm members, each having a transmission roller, and a single drive roller which has an axial length sufficient to drive the plurality of transmission rollers.

Reference is made, by way of example, to the accompanying drawings, in which:-
Figs. 1(a) and 1(b) schematically illustrate a prior art wafer positioning method utilising orientation flats on wafers,
Fig. 2 is a partial perspective view illustrating an embodiment of the present invention,
Fig. 3 shows a perspective view, to a larger scale, of a part of the embodiment of Fig. 2, with a wafer rotating and sliding on a protrusion on an arm member,
Fig. 4 shows a perspective view, to a larger scale, of a part of the embodiment of Fig. 2, when the notch in a wafer is engaged with the protrusion, showing separation from a transmission roller,
Fig. 5 is a perspective view of an embodiment of the present invention in which a plurality of arm members are provided and driven by a single drive roller of sufficient length,
Fig. 6 illustrates the shape of a notch formed in a wafer,
Fig. 7 is a cross-sectional view illustrating an embodiment of the present invention when a carrier containing wafers is disposed on the positioning mechanism,
Fig. 8 is a top view, with portions broken away, of the embodiment of the present invention when the carrier is disposed on the positioning mechanism, and
Fig. 9 illustrates relative arrangements of wafer, transmission roller, arm member and drive roller of an embodiment of the present invention.

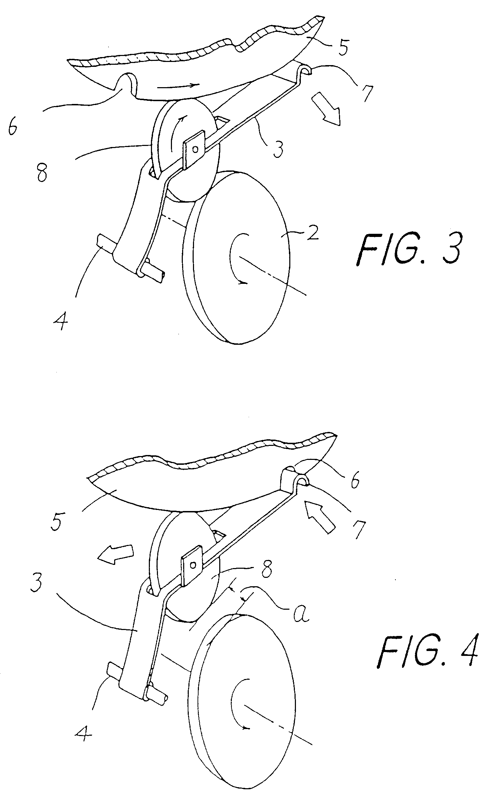

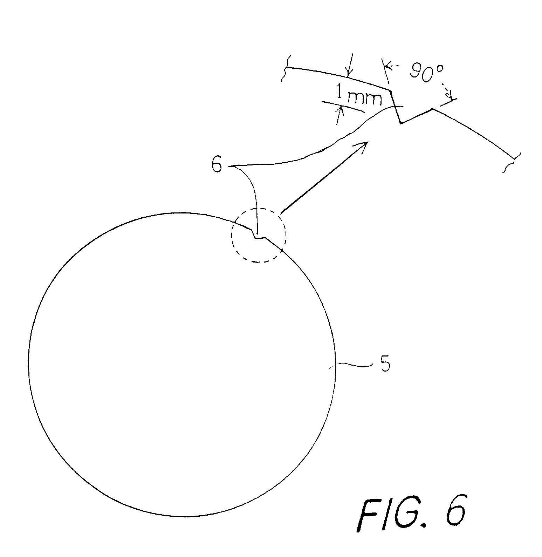

Figs. 2 to 4 give perspective views illustrating an embodiment of the present invention, for easy understanding. In Fig. 2, a semiconductor wafer 5 is shown loaded in a carrier 10 (which carrier is partly shown in cross-section, holding a single wafer, for the sake of clarity). The wafer is supported vertically and a notch 6 is formed in the periphery of the wafer 5. The notch 6 has a V-shape with an aperture angle of about 90° and a depth of about 1 mm from the circular periphery of the wafer, as shown in Fig. 6. An arm member 3 having an elastic or flexible or resilient characteristic, is provided under the wafer 5, and a transmission roller 8 is supported by the arm member 3 and a drive roller 2 is disposed under the wafer 5 and transmission roller 8. One end of the arm member 3 is fixed by a fixing means 4 such as a rod, and another end thereof protrudes towards the wafer, forming a protrusion 7. The external shape of the protrusion 7 is chosen such that it can fall into the notch 6 when the notch moves on to the protrusion 7.

Fig. 3 shows a perspective view, to an enlarged scale as compared with Fig. 2, of the positioning mechanism when the protrusion 7 is sliding on the periphery of the wafer outside of the notch 6, and Fig. 4 shows a view similar to that of Fig. 3 when the protrusion 7 falls into the notch 6. As shown in Fig. 3, when the protrusion 7 is pressed in a downward direction, indicated by an arrow outline, (holding means of the carrier and the positioning mechanism will be explained below) by the wafer periphery, the arm member 3, which is formed with a V-shape, is further deformed and the transmission roller 8 is pressed onto the drive roller 2 and rotates, resulting in rotation of the wafer 5. As shown in Fig. 4, when the protrusion 7 engages with the notch 6 under the effects of a restoring force of the arm member 3, the contact of the transmission roller 8 with the drive roller 2 is released and a gap a is formed between those rollers, with the result that rotations of both the transmission roller 8 and wafer 5 cease.

Therefore, regardless of the initial notch position of the wafer, the notch position is brought to a predetermined specified position within one rotation of the wafer.

In the embodiment shown in Figs. 2 to 4, the drive roller 2 of the positioning mechanism 1 has a diameter of about 36 mm, and is provided by a metal roller coated with material such as a silicone rubber and/or a urethane rubber. The arm member 3 is fabricated of stainless steel sheet having a thickness of 0.2 mm and a width of 4 mm, and is formed beforehand to a V-shape. The protrusion 7 is formed by bending one end of the arm member 3 and it has a V-shape in cross-section. The shape of the protrusion engages gently within the notch 6 formed on the periphery of the wafer 5. Therefore, when the periphery of the wafer 5 rotates, sliding on the protrusion 7, the protrusion 7 becomes engaged with the notch 6. At this time, the transmission roller 8 separates from the drive roller 2, and wafer rotation ceases.

The transmission roller 8 in this embodiment is set in an opening in and rotatably supported at a middle portion of the arm member 3, and it has a diameter of 20 mm and is made of, for example, polyacetal in order to avoid contamination of the wafer 5. The transmission roller 8 may be supported by a cantilever axis fixed on one side of the arm member 3.

A U-shaped groove having a width of 1 mm and a depth of 1 mm is preferably formed on or around the cylindrical surface of the transmission roller 8, such that the peripheral edge of the wafer 5 fits into the groove so that the wafer does not run off the transmission roller.

The fixing means 4 of this embodiment utilises a stainless steel rod 3 mm in diameter, to which the arm member 3 is fixed.

When a plurality of positioning mechanisms 1 as shown in Figs. 2 to 4 are connected and assembled together side by side in an axial direction, a plurality of wafers can be positioned at one time even when the wafers 5 are placed in the carrier irregularly with regard to the notch positions. Each wafer ceases rotation at a time when the protrusion 7 formed on a corresponding arm member 3 engages with the notch 6 in the wafer. Within the time taken for one wafer rotation, all wafers are positioned in a manner such that the notch positions are aligned in an axial direction.

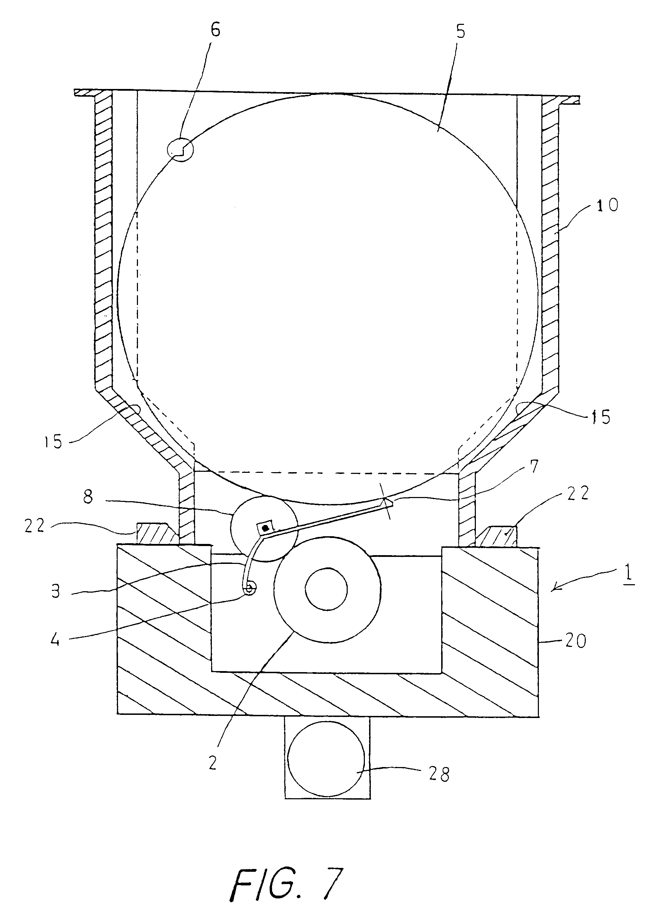

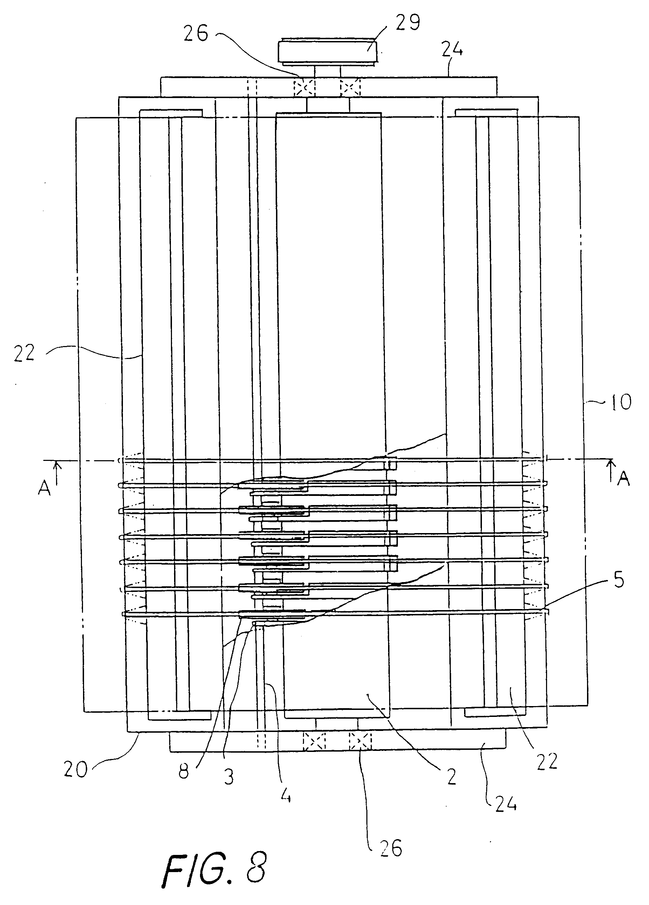

Fig. 2 provides only a partial view of such an embodiment. A fuller view of a positioning mechanism in accordance with such an embodiment of the invention, for positioning a plurality of semiconductor wafers placed in a carrier, is given by Figs. 7 and 8. Fig. 7 shows a cross-section, taken along a line A-A of Fig. 8, when a carrier 10 containing a plurality of wafers 5 is disposed on a positioning mechanism 1 embodying the invention. Fig. 8 is a top view (looking down on the container), but for the sake of clarity, only the outline of the carrier 10 is shown, by a chain line, and wafers 5, arm members 3 and transmission rollers 8 are only partly shown. It can be seen that semiconductor wafers are arranged in the carrier 10 at small, regular intervals of about 5 to 6 mm between adjacent wafers.

The carrier 10 is, for instance, made of polypropylene and wafers 5 are supported on sloped side walls 15 as shown in Fig. 7. For positioning the wafers, the carrier 10 is disposed on a holder base 20, and in a longitudinal direction the carrier is thereby aligned by carrier guides 22 attached to the holder base 20. The protrusion 7 of the arm member 3 seen in Fig. 7 and the periphery of the transmission roller 8 exert a force tending to raise the wafer. On the other hand, the transmission roller 8 is pressed against the drive roller 2. Therefore, a wafer having dimensions such as 150 mm (6 inches) or 200 mm (8 inches) diameter and 0.7 mm thickness, can easily be rotated, sliding on side walls 15. Fig. 8 illustrates that the (each) transmission roller 8 is supported by a cantilever fixed on the (a respective) arm member 3, and that the axis of the drive roller 2 is supported by side walls 24 via a bearing 26 and driven by a belt 29 coupled to a motor 28 (Fig. 7).

The fixing means 4, for example a rod, is also fixed to side walls 24 which form holding means with the holder base 20, position of fixing being adjusted such that, when a protrusion 7 is depressed downward by the periphery of the wafer, an arm member 3 is bent and a transmission roller 8 is pushed on to the drive roller 2, and further such that, when a protrusion engages with a notch 6, the arm member is lifted up by elastic or resilient force and a gap is formed between the transmission roller 8 and drive roller 2, resulting in cessation of rotation of the wafer.

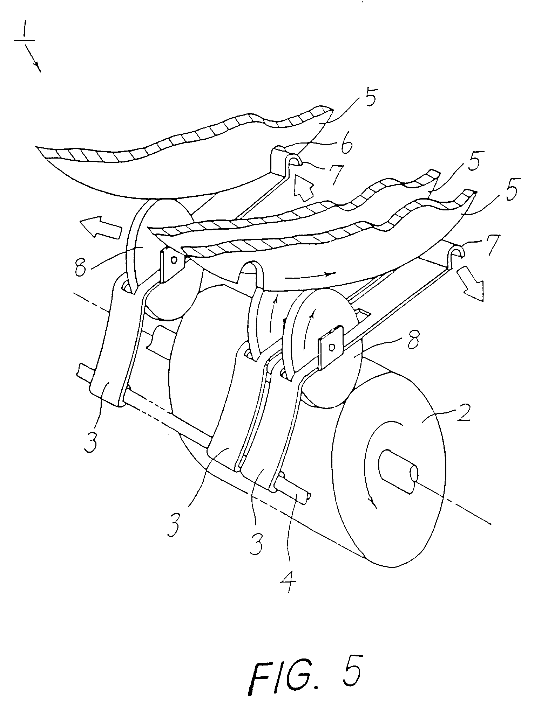

Fig. 5 shows a perspective view, to an enlarged scale as compared with Fig. 7, of detailed structure of a combination of the single drive roller 2 and a plurality of arm members 3, each arm member having a transmission roller 8. Each transmission roller 8 fulfils the functions of rotating and positioning a single wafer (placed in the carrier with irregular random orientation). In Fig. 5, a drive roller 2 is of sufficient length to rotate the plurality of transmission rollers 8, and fixing means 4 has also a sufficient length for fixing the same number of arm members 3. For example, when a carrier is capable of holding 25 wafers at regular intervals of about 5 to 6 mm, the axial lengths of both the drive roller 2 and fixing means 4 are chosen to be about 130 to 160 mm.

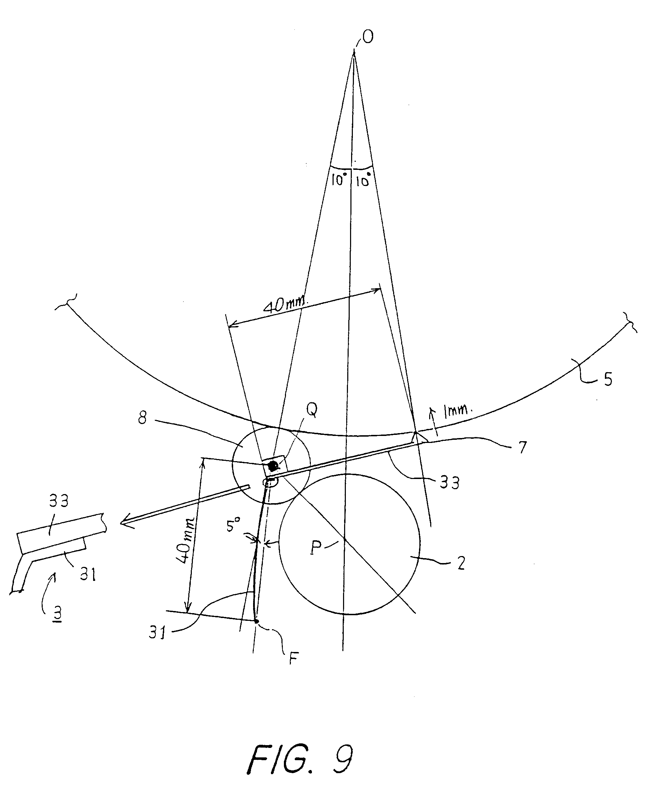

Now, an example of the relative arrangements of wafer 5, transmission roller 8, drive roller 2 and arm member 3 will be explained with reference to the side view of Fig. 9. In this case, diameters of wafer 5, transmission roller 8 and drive roller 2 are selected to be 200, 20 and 36 mm respectively. An arm member 3 is formed by soldering or welding together two parts 31 and 33, each having a length of about 40 mm. The first part 31 is of phosphor bronze having a spring characteristic, and a thickness thereof is about 0.5 mm. The second part 33 is a machined part of steel sheet having a thickness of about 1 mm and exercises substantially no spring action.

The centre position Q of the transmission roller 8 is located on a line forming an angle of 10° with a line O-P (herein, O and P designate the centre of a wafer 5 and drive roller 2 respectively). A connecting line between protrusion 7 and the centre O also forms an angle of about 10° with line O-P. The arm member 3 is bent and forms a V-shape. The fixing point F of the arm member 3 is determined such that the position F is located to the right (as seen in Fig.9) of an extension of line O-Q, forming an angle of about 5° therewith, as shown in Fig. 9.

When the above design structure is utilised for the positioning mechanism, the transmission roller 8 is separated from the drive roller 2 with a gap of 0.5 mm when protrusion 7 engages with notch 6 having a depth of 1 mm.

The positioning mechanism 1 in accordance with an embodiment of the present invention is arranged under the carrier 10 as shown in Figs. 7 and 8, and the drive roller 2 is rotated at a peripheral speed of the wafer of about 50 mm per second. A satisfactory result can be obtained for positioning the wafer within a single rotation thereof.

All dimensions, shapes and materials of wafer 5, notch 6, arm member 3, protrusion 7, transmission roller 8, drive roller 2, etc., disclosed above are exemplary: it will be apparent that other embodiments of the invention are possible. Further, the number of wafers to be positioned at one time and the rotation speeds of movable parts are also exemplary.

A wafer positioning mechanism embodying the present invention, for notched wafers, the notch which is a substitute for the orientation flat of the prior art, can cope with an increased wafer size, with the object of getting a larger yield of chips from a single wafer and of getting a more uniform processed surface for wafers. Positioning mechanisms embodying the invention can be utilised for positioning not only a single wafer but also a plurality of wafers in the carrier at one time.

Embodiments of the present invention provide that wafers placed in a carrier during wafer processing can be positioned in a short time, just before a next process step, for the purpose of prealignment, and are useful for improving wafer processing.

## Claims

1. A wafer positioning mechanism, for positioning a wafer with a notch in the periphery thereof, the positioning mechanism comprising:-
a drive roller, the centre axis thereof being substantially perpendicular to the main wafer surfaces, when the wafer is mounted for positioning by the mechanism, and being coupled to a drive source;
an arm member, a first end thereof being fixed and a second end having a protrusion and being elastically displaceable towards and away from the periphery of the wafer when the wafer is mounted for positioning by the mechanism, and the protrusion having a shape for fitting the notch in the periphery of the wafer;
a transmission roller, which is, with its periphery, in contact with the periphery of the wafer when the wafer is mounted for positioning by the mechanism, and which is supported by the arm member between the first and second ends thereof, the centre axis of the transmission roller being substantially parallel to the centre axis of the drive roller; and
holding means, for holding the arm member and drive roller in the vicinity of said wafer, so that said transmission roller is driven by said drive roller, whereby the wafer is rotated, when said protrusion is in contact with the wafer periphery outside the region where the notch is formed and so that the transmission roller loses contact with the drive roller when said protrusion is engaged with the notch.

2. A positioning mechanism as claimed in claim 1, wherein said positioning mechanism comprises a plurality of arm members and transmission rollers, combined with respective arm members, and said drive roller has an axial length sufficient to allow it to drive all of the transmission rollers, whereby a plurality of wafers can be positioned at one time.

3. A positioning mechanism as claimed in claim 1 or 2, wherein the or each arm member is formed of a spring sheet having a V-shape, and is further deformed, towards the drive roller, when a wafer is mounted for positioning by the mechanism and arranged on the arm member, the periphery of the wafer contacting the transmission roller of the arm member concerned and contacting said protrusion.

4. A positioning mechanism as claimed in claim 1 or 2, wherein the or each arm member is made of two sheet parts connected with one another at a middle point of the arm member and forming a V-shape, the first part being of spring material and one end thereof forming the first end of the arm member, the arm member being deformed, towards the drive roller, when a wafer is mounted for positioning by the mechanism and arranged on the arm member, the periphery of the wafer contacting the transmission roller of the arm member concerned and contacting said protrusion.

5. A positioning mechanism as claimed in claim 3, wherein a hole or aperture is formed in the or each arm member, and the or the corresponding transmission roller is set in the aperture supported on a surrounding portion of the arm member around the aperture.

6. A positioning mechanism as claimed in claim 4, wherein the or each transmission roller is supported at the middle point of the or the corresponding arm member.

7. A positioning mechanism as claimed in any preceding claim, wherein the wafer or wafers for positioning by the mechanism are placed in a container and the container is a semiconductor wafer carrier for holding wafers spaced at regular intervals and having an opening at a bottom portion thereof through which a substantial bottom portion of the wafer periphery of the or each wafer contained therein is exposed, and wherein said holding means comprises a holder base and a carrier guide having dimensions adapted so that the drive roller and the arm member or arm members are disposed appropriately when the carrier is in place on the mechanism.

8. A positioning mechanism as claimed in any preceding claim, wherein the or each transmission roller has a groove formed in the cylindrical surface thereof, the width of the groove being greater than a thickness of a wafer with which the positioning mechanism is used.

9. A positioning mechanism as claimed in any preceding claim, wherein the or each arm member is fixed, at its first end, by a fixing means to a side wall which is a constituent part of the holding means.

10. A positioning mechanism as claimed in claim 9, wherein said fixing means of the or each arm member includes a rod.

11. A positioning mechanism as claimed in claim 9, wherein the position of said fixing means is displaced from a line connecting the centres of the wafer and the transmission roller, towards the drive roller.

## Patentansprüche

1. Scheibenpositioniervorrichtung zum Positionieren einer Scheibe mit einer Kerbe auf ihrem Umfang, wobei die Positioniervorrichtung umfaßt:-
eine Antriebsrolle, deren Mittelachse im wesentlichen senkrecht zu den hauptsächlichen Scheibenoberflächen ist, wenn die Scheibe zum Positionieren mittels der Vorrichtung angebracht ist, und die mit einer Antriebsquelle verbunden ist;
ein Armelement, von dem ein erstes Ende ortsfest ist und ein zweites Ende einen Vorsprung aufweist und elastisch auf den Umfang der Scheibe zu und von diesem weg verschiebbar ist, wenn die Scheibe zum Positionieren mittels der Vorrichtung angebracht ist, und wobei der Vorsprung eine solche Form aufweist, daß er in die Kerbe auf dem Umfang der Scheibe paßt;
eine Transmissionsrolle, die mit ihrem Umfang in Berührung mit dem Umfang der Scheibe ist, wenn die Scheibe zum Positionieren mittels der Vorrichtung angebracht ist, und die von dem Armelement zwischen dessen erstem und zweitem Ende getragen wird, wobei die Mittelachse der Transmissionsrolle im wesentlichen parallel zur Mittelachse der Antriebsrolle ist; und
eine Haltevorrichtung, um das Armelement und die Antriebsrolle in der Nähe der Scheibe zu halten, so daß die Transmissionsrolle durch die Antriebsrolle angetrieben wird, wodurch die Scheibe gedreht wird, wenn sich der Vorsprung außerhalb des Bereichs, wo die Kerbe ausgebildet ist, in Berührung mit dem Scheibenumfang befindet, und so, daß die Transmissionsrolle die Berührung mit der Antriebsrolle verliert, wenn der Vorsprung mit der Kerbe im Eingriff steht.

2. Positioniervorrichtung nach Anspruch 1, bei der die Positioniervorrichtung eine Mehrzahl von Armelementen und mit entsprechenden Armelementen kombinierten Transmissionsrollen umfaßt und bei der die Antriebsrolle eine ausreichende axiale Länge aufweist, so daß sie alle Transmissionsrollen antreiben kann, wodurch eine Mehrzahl von Scheiben gleichzeitig positioniert werden kann.

3. Positioniervorrichtung nach Anspruch 1 oder 2, bei der das oder jedes Armelement aus einem Federblech, das eine V-Form aufweist, gebildet ist und weiterhin auf die Antriebsrolle zu verformt wird, wenn eine Scheibe zum Positionieren mittels der Vorrichtung angebracht wird und auf dem Armelelement angeordnet wird, wobei der Umfang der Scheibe die Transmissionsrolle des betreffenden Armelements berührt und den Vorsprung berührt.

4. Positioniervorrichtung nach Anspruch 1 oder 2, bei der das oder jedes Armelement aus zwei Blechteilen hergestellt ist, die in einem mittleren Punkt des Armelements miteinander verbunden sind und eine V-Form bilden, wobei der erste Teil aus Federmaterial besteht, und wobei ein Ende desselben das erste Ende des Armelements bildet, wobei das Armelement auf die Antriebsrolle zu verformt wird, wenn eine Scheibe zum Positionieren mittels der Vorrichtung angebracht wird und auf dem Armelement angeordnet wird, wobei der Umfang der Scheibe die Transmissionsrolle des betreffenden Armelements berührt und den Vorsprung berührt.

5. Positioniervorrichtung nach Anspruch 3, bei der ein Loch oder eine Öffnung in dem oder jedem Armelement ausgebildet ist und die oder die entsprechende Transmissionsrolle in die Öffnung eingesetzt ist, abgestützt auf einem umgebenden Abschnitt des Armelements rund um die Öffnung.

6. Positioniervorrichtung nach Anspruch 4, bei der die oder jede Transmissionsrolle am mittleren Punkt des oder des entsprechenden Armelements abgestützt ist.

7. Positioniervorrichtung nach einem beliebigen vorangehenden Anspruch, bei der die Scheibe oder die Scheiben zum Positionieren mittels der Vorrichtung in einen Behälter gestellt sind und der Behälter ein Halbleiterscheibenträger zum Halten der Scheiben in regelmäßigen Abständen und mit einer Öffnung an einem Bodenabschnitt desselben ist, durch welche ein beträchtlicher unterer Teilbereich des Scheibenumfangs der oder jeder darin enthaltenen Scheibe freigelegt wird, und bei der die Haltevorrichtung einen Haltesockel und eine Trägerführung umfaßt, die Abmessungen aufweisen, die so angepaßt sind, daß die Antriebsrolle und das Armelement oder die Armelemente passend angeordnet sind, wenn sich der Träger in seiner Lage auf der Vorrichtung befindet.

8. Positioniervorrichtung nach einem beliebigen vorangehenden Anspruch, bei der die oder jede Transmissionsrolle eine Nut aufweist, die in ihrer zylindrischer Oberfläche ausgebildet ist, wobei die Breite der Nut größer als eine Dicke einer Scheibe ist, für die die Positioniervorrichtung verwendet wird.

9. Positioniervorrichtung nach einem beliebigen vorangehenden Anspruch, bei der das oder jedes Armelement an seinem ersten Ende durch eine Befestigungsvorrichtung an einer Seitenwand befestigt ist, die ein wesentlicher Bestandteil der Haltevorrichtung ist.

10. Positioniervorrichtung nach Anspruch 9, bei der die Befestigungsvorrichtung des oder jedes Armelements eine Stange umfaßt.

11. Positioniervorrichtung nach Anspruch 9, bei der die Position der Befestigungsvorrichtung von einer Linie, die die Mittelpunkte der Scheibe und der Transmissionsrolle verbindet, auf die Antriebsrolle zu verschoben ist.

## Revendications

1. Mécanisme de positionnement de plaquettes, destiné à positionner une plaquette avec une entaille à la périphérie de celle-ci, le mécanisme de positionnement comprenant :
un galet d'entraînement, dont l'axe central est sensiblement perpendiculaire aux surfaces principales de la plaquette lorsque la plaquette est montée pour être positionnée par le mécanisme, et qui est accouplé à une source d'entraînement;
un élément en forme de bras, dont une première extrémité est fixée et une seconde extrémité porte une saillie, ledit bras étant élastiquement déplaçable en direction et en éloignement de la périphérie de la plaquette lorsque la plaquette est montée pour être positionnée par le mécanisme, et la saillie ayant une forme destinée à s'emboîter dans l'entaille dans la périphérie de la plaquette;
un galet de transmission qui est en contact par sa périphérie contre la périphérie de la plaquette lorsque la plaquette est montée pour être positionnée par le mécanisme, et qui est supporté par le bras entre la première et la seconde extrémité de celui-ci, l'axe central du galet de transmission étant sensiblement parallèle à l'axe central du galet d'entraînement; et
des moyens de support destiné à supporter le bras et le galet d'entraînement au voisinage de ladite plaquette, de telle manière que ledit galet de transmission soit entraîné par ledit galet d'entraînement, grâce à quoi la plaquette est mise en rotation lorsque ladite saillie est en contact avec la périphérie de la plaquette à l'extérieur de la région où est formée l'entaille, et de sorte que le galet de transmission quitte le contact avec le galet d'entraînement lorsque ladite saillie est en engagement dans ladite entaille.

2. Mécanisme de positionnement selon la revendication 1, dans lequel ledit mécanisme de positionnement comprend une pluralité de bras et de galets de transmission, combinés avec des bras respectifs, et ledit galet d'entraînement a une longueur axiale suffisante pour lui permettre d'entraîner tous les galets de transmission, grâce à quoi on peut positionner en une seule fois une pluralité de plaquettes.

3. Mécanisme de positionnement selon l'une ou l'autre des revendications 1 et 2, dans lequel ledit bras ou chaque bras est formé à partir d'une feuille élastique ayant une forme en V, et est déformé en direction du galet d'entraînement lorsqu'une plaquette est montée afin d'être positionnée par le mécanisme et agencée sur le bras, la périphérie de la plaquette faisant contact avec le galet de transmission du bras concerné et faisant contact avec ladite saillie.

4. Mécanisme de positionnement selon l'une ou l'autre des revendications 1 et 2, dans lequel le bras ou chaque bras est réalisé en deux parties en tôle reliées l'une à l'autre en point médian du bras et constituant une forme en V, la première partie étant en matériau élastique et une de ses extrémités formant la première extrémité du bras, le bras étant déformé en direction du galet d'entraînement lorsqu'une plaquette est montée afin d'être positionnée par le mécanisme et agencée sur le bras, la périphérie de la plaquette faisant contact avec le galet de transmission du bras concerné et faisant contact avec ladite saillie.

5. Mécanisme de positionnement selon la revendication 3, dans lequel un trou ou une ouverture est formé dans le bras ou dans chaque bras, et le galet de transmission, ou le galet de transmission correspondant, est placé dans l'ouverture en étant supporté sur une partie du bras qui entoure l'ouverture.

6. Mécanisme de positionnement selon la revendication 4, dans lequel le galet de transmission ou chaque galet de transmission est supporté au point central du bras ou du bras correspondant.

7. Mécanisme de positionnement selon l'une quelconque des revendications précédentes, dans lequel la plaquette ou les plaquettes à positionner par le mécanisme sont placées dans un container et le container est un porte-plaquette destiné à porter des plaquettes semi-conductrices écartées à des intervalles réguliers, et présentant une ouverture à une partie inférieure du container, à travers laquelle une partie inférieure notable de la périphérie de la plaquette ou de chaque plaquette contenue dans le container est exposée, et dans lequel lesdits moyens de support comprennent une base et un guide de support ayant des dimensions adaptées de telle manière que le galet d'entraînement et le bras ou les bras sont disposés de façon appropriée lorsque le support est en place sur le mécanisme.

8. Mécanisme de positionnement selon l'une quelconque des revendications précédentes, dans lequel le galet de transmission ou chaque galet de transmission présente une gorge formée dans la surface cylindrique de celui-ci, la largeur de la gorge étant supérieure à l'épaisseur d'une plaquette avec laquelle le mécanisme de positionnement est utilisé.

9. Mécanisme de positionnement selon l'une quelconque des revendications précédentes, dans lequel le bras ou chaque bras est fixé à sa première extrémité au moyen d'un organe de fixation, sur une paroi latérale qui est une partie constitutive des moyens de support.

10. Mécanisme de positionnement selon la revendication 9, dans lequel lesdits moyens de fixation du bras ou de chaque bras comprennent une tige.

11. Mécanisme de positionnement selon la revendication 9, dans lequel la position desdits moyens de fixation est déplacée depuis une ligne qui relie les centres de la plaquette et du galet de transmission, en direction du galet d'entraînement.
